# EUROPEAN PATENT APPLICATION

(11) **EP 4 080 697 A1**
(43) Date of publication of application: **26.10.2022**
(21) Application number: 20903678.9
(22) Date of filing: 10.12.2020
(51) Int. Cl.: H01S 5/183, H01S 5/22, H01S 5/42

(54) **LIGHT-EMITTING DEVICE AND METHOD FOR MANUFACTURING LIGHT-EMITTING DEVICE**

(30) Priority: 20.12.2019 JP 2019230070
(71) Applicant: Sony Semiconductor Solutions Corporation, Atsugi-shi, Kanagawa 243-0014 (JP)
(72) Inventor: ARAKIDA, Takahiro, Kikuchi-gun, Kumamoto 869-1102 (JP)
(74) Representative: D Young & Co LLP
(86) International application number: PCT/JP2020/046122
(87) International publication number: WO 2021/125054

(57) **Abstract**

A light emitting device according to an embodiment of the present disclosure includes: a semi-insulating substrate; a semiconductor layer; a semiconductor stacked body; a buried layer; and a non-continuous lattice plane. The semi-insulating substrate has a first surface and a second surface that are opposed to each other. The semiconductor layer is stacked on the first surface of the semi-insulating substrate. The semiconductor layer has electrical conductivity. The semiconductor stacked body is stacked above the first surface of the semi-insulating substrate with the semiconductor layer interposed in between. The semiconductor stacked body has a light emitting region and includes a ridge section on the semi-insulating substrate side. The light emitting region is configured to emit laser light. The buried layer is provided around the ridge section of the semiconductor stacked body. The non-continuous lattice plane is provided between the semi-insulating substrate and the semiconductor stacked body.

## Description

### Technical Field

The present disclosure relates, for example, to a light emitting device having a ridge structure and a method of manufacturing a light emitting device.

### Background Art

For example, PTL 1 discloses an optical semiconductor device in which a first semiconductor section and a second semiconductor section are electrically joined in a minute region for current confinement formed in one of the first semiconductor section and the second semiconductor section.

### Citation List

### Patent Literature

PTL 1: Japanese Unexamined Patent Application Publication No. H11-266056

### Summary of the Invention

Incidentally, a ridge confinement type surface emitting laser is requested to have higher reliability.

It is desirable to provide a light emitting device that makes it possible to increase the reliability and a method of manufacturing a light emitting device.

A light emitting device according to an embodiment of the present disclosure includes: a semi-insulating substrate; a semiconductor layer; a semiconductor stacked body; a buried layer; and a non-continuous lattice plane. The semi-insulating substrate has a first surface and a second surface that are opposed to each other. The semiconductor layer is stacked on the first surface of the semi-insulating substrate. The semiconductor layer has electrical conductivity. The semiconductor stacked body is stacked above the first surface of the semi-insulating substrate with the semiconductor layer interposed in between. The semiconductor stacked body has a light emitting region and includes a ridge section on the semi-insulating substrate side. The light emitting region is configured to emit laser light. The buried layer is provided around the ridge section of the semiconductor stacked body. The non-continuous lattice plane is provided between the semi-insulating substrate and the semiconductor stacked body.

A method of manufacturing a light emitting device according to an embodiment of the present disclosure includes: forming a ridge section in a semiconductor stacked body having a light emitting region configured to emit laser light; forming a buried layer around the ridge section; and bonding the ridge section and a semi-insulating substrate with a semiconductor layer interposed in between. The semi-insulating substrate has a first surface and a second surface that are opposed to each other. The semiconductor layer has electrical conductivity.

In the light emitting device according to an embodiment of the present disclosure and the method of manufacturing the light emitting device according to the embodiment, the semiconductor stacked body includes the ridge section and is provided with the buried layer around the ridge section and the ridge section of the semiconductor stacked body is joined to the first surface of the semi-insulating substrate with the semiconductor layer interposed in between. The semiconductor layer has electrical conductivity. This increases the mechanical strength of the ridge section.

### Brief Description of Drawing

[FIG. 1] FIG. 1 is a cross-sectional schematic diagram illustrating an example of a configuration of a semiconductor laser according to an embodiment of the present disclosure.
[FIG. 2A] FIG. 2A is a cross-sectional schematic diagram describing an example of a method of manufacturing the semiconductor laser illustrated in FIG. 1.
[FIG. 2B] FIG. 2B is a cross-sectional schematic diagram illustrating a step subsequent to FIG. 2A.
[FIG. 2C] FIG. 2C is a cross-sectional schematic diagram illustrating a step subsequent to FIG. 2B.
[FIG. 2D] FIG. 2D is a cross-sectional schematic diagram illustrating a step subsequent to FIG. 2C.
[FIG. 2E] FIG. 2E is a cross-sectional schematic diagram illustrating a step subsequent to FIG. 2D.
[FIG. 2F] FIG. 2F is a cross-sectional schematic diagram illustrating a step subsequent to FIG. 2E.
[FIG. 2G] FIG. 2G is a cross-sectional schematic diagram illustrating a step subsequent to FIG. 2F.
[FIG. 2H] FIG. 2H is a cross-sectional schematic diagram illustrating a step subsequent to FIG. 2G.
[FIG. 21] FIG. 21 is a cross-sectional schematic diagram illustrating a step subsequent to FIG. 2H.

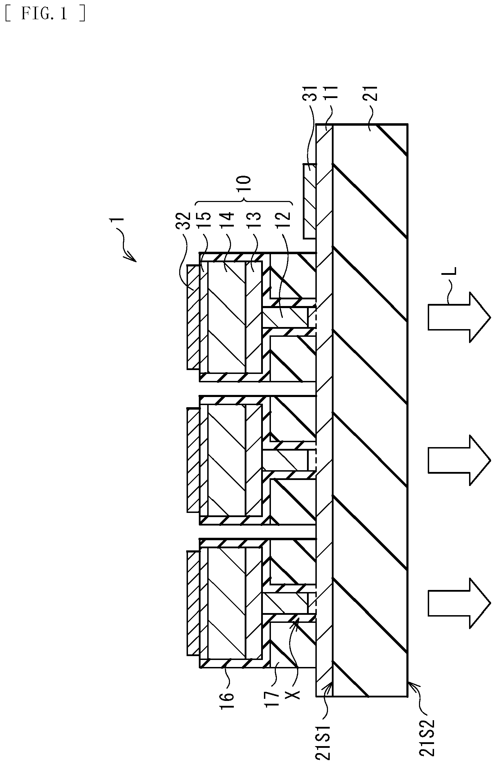

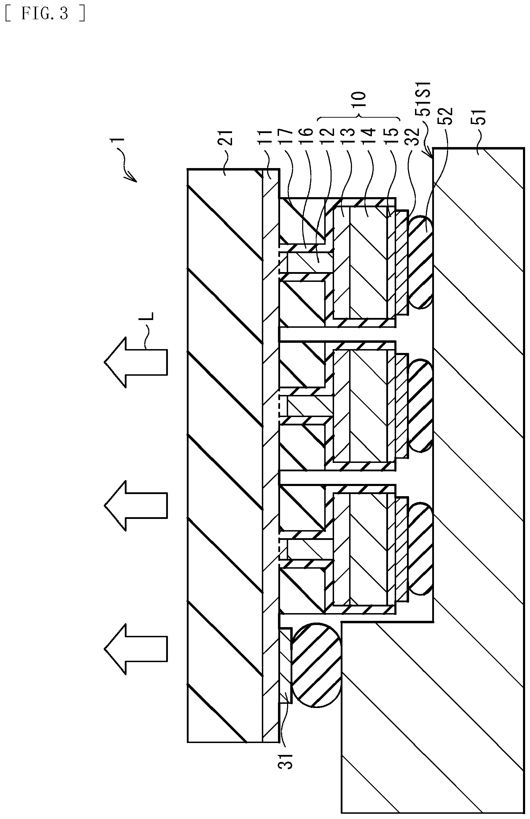

[FIG. 3] FIG. 3 is a cross-sectional schematic diagram illustrating an example of a configuration of a light emitting apparatus in which the semiconductor laser illustrated in FIG. 1 is mounted on a mounting substrate.

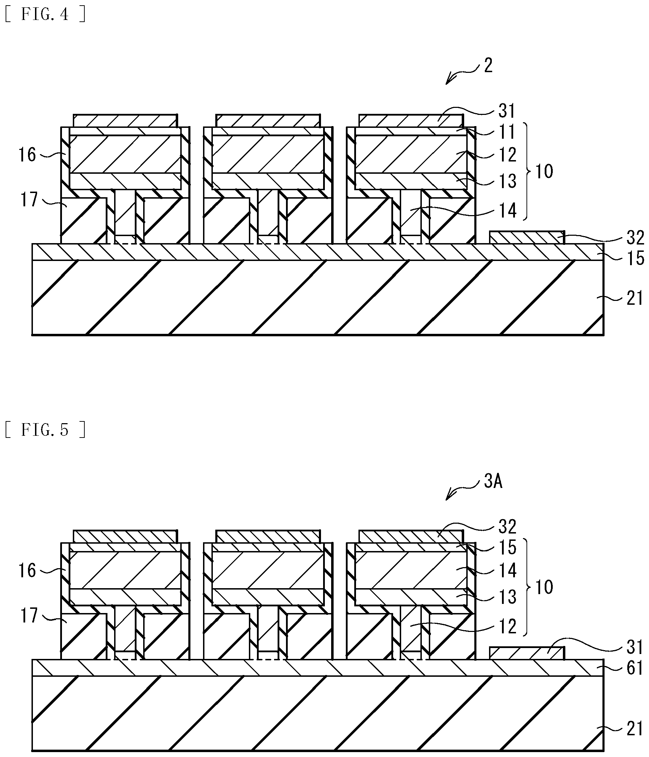

[FIG. 4] FIG. 4 is a cross-sectional schematic diagram illustrating an example of a configuration of a semiconductor laser according to a modification example 1 of the present disclosure.
[FIG. 5] FIG. 5 is a cross-sectional schematic diagram illustrating an example of a configuration of a semiconductor laser according to a modification example 2 of the present disclosure.

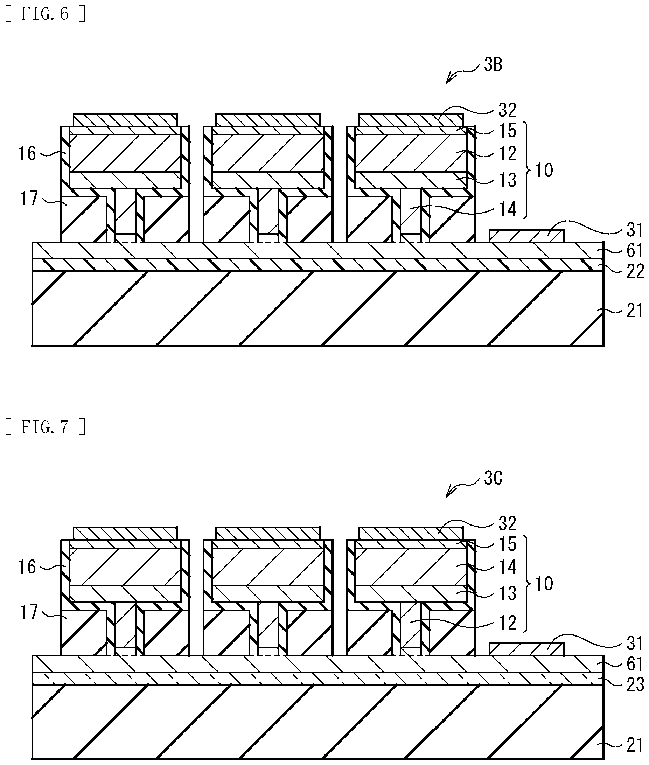

[FIG. 6] FIG. 6 is a cross-sectional schematic diagram illustrating another example of the configuration of the semiconductor laser according to the modification example 2 of the present disclosure.
[FIG. 7] FIG. 7 is a cross-sectional schematic diagram illustrating another example of the configuration of the semiconductor laser according to the modification example 2 of the present disclosure.

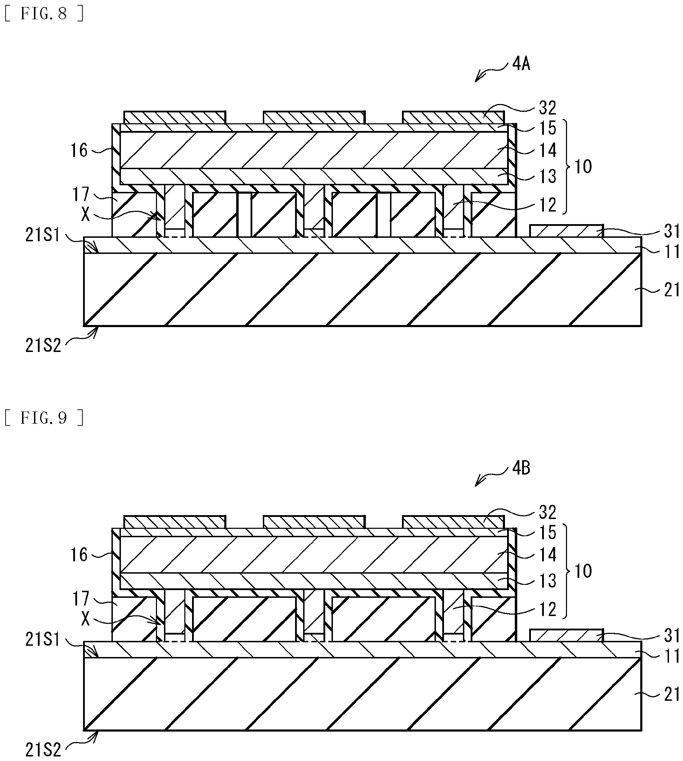

[FIG. 8] FIG. 8 is a cross-sectional schematic diagram illustrating an example of a configuration of a semiconductor laser according to a modification example 3 of the present disclosure.
[FIG. 9] FIG. 9 is a cross-sectional schematic diagram illustrating another example of the configuration of the semiconductor laser according to the modification example 3 of the present disclosure.

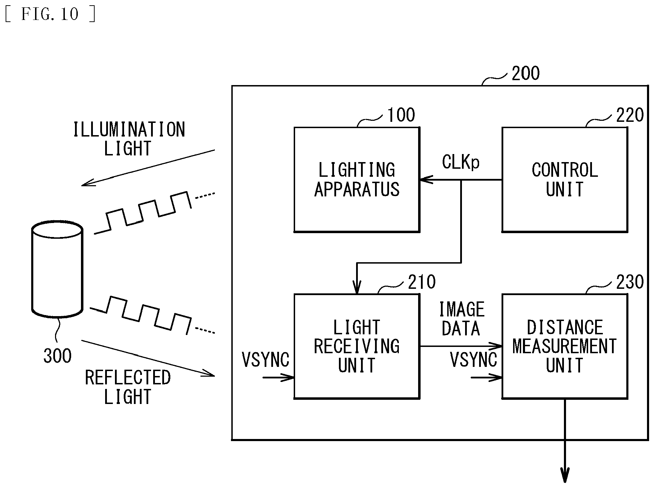

[FIG. 10] FIG. 10 is a block diagram illustrating an example of a schematic configuration of a distance measurement system including the light emitting apparatus illustrated in FIG. 3.

### Modes for Carrying Out the Invention

The following describes an embodiment of the present disclosure in detail with reference to the drawings. The following description is a specific example of the present disclosure, but the present disclosure is not limited to the following modes. In addition, the present disclosure is not limited to the disposition, dimensions, dimensional ratios, or the like of the respective components illustrated in the drawings. It is to be noted that description is given in the following order.
1. Embodiment (an example of a semiconductor laser that is provided with a buried layer around a ridge section and has the ridge section opposed and joined to a semi-insulating substrate)
   1-1. Configuration of Semiconductor Laser
   1-2. Method of Manufacturing Semiconductor Laser
   1-3. Workings and Effects
2. Modification Examples
   2-1. Modification Example 1 (another configuration example of a semiconductor laser)
   2-2. Modification Example 2 (another configuration example of a semiconductor laser)
   2-3. Modification Example 3 (another configuration example of a semiconductor laser)
3. Application Example (an example of a distance measurement system)

### <1. Embodiment>

FIG. 1 schematically illustrates an example of a cross-sectional configuration of a light emitting device (semiconductor laser 1) according to an embodiment of the present disclosure. This semiconductor laser 1 is, for example, back-emitting VCSEL (Vertical Cavity Surface Emitting LASER) having a ridge structure. For example, a plurality of VCSELs is integrated in an array as a plurality of light emitting regions.

### (1-1. Configuration of Semiconductor Laser)

The semiconductor laser 1 includes, for example, a plurality of semiconductor stacked bodies 10 on a first surface (front surface (surface 21S1)) of a semi-insulating substrate 21. Each of the semiconductor stacked bodies 10 has a mesa shape. In the semiconductor stacked body 10, for example, a first light reflecting layer 12, an active layer 13, a second light reflecting layer 14, and a second contact layer 15 are stacked in this order. One (e.g., first light reflecting layer 12) of the light reflecting layers is included in a ridge section X having a protruding shape. The side surfaces of the semiconductor stacked body 10 is covered with an insulating film 16. Specifically, the side surfaces of the first light reflecting layer 12 included in the ridge section X, the upper surface and the side surfaces of the active layer 13, the side surfaces of the second light reflecting layer 14, and the side surfaces of the second contact layer 15 are covered with the insulating film 16. Further, there is provided a buried layer 17 around the ridge section X. For example, the buried layer 17 forms substantially the same side surfaces as the side surfaces of the active layer 13, the second light reflecting layer 14, and the second contact layer 15. This causes the semiconductor stacked body 10 including the buried layer 17 to have, for example, a columnar shape. The semiconductor stacked body 10 is joined to the front surface (surface 21S1) of the semi-insulating substrate 21 from the ridge section X side with a first contact layer 11 interposed in between. The first contact layer 11 has electrical conductivity. The semiconductor stacked body 10 has a non-continuous lattice plane between the semiconductor stacked body 10 and the semi-insulating substrate 21.

The first contact layer 11 includes, for example, a GaAs-based semiconductor having electrical conductivity. The first contact layer 11 includes, for example, p-type GaAs. The first contact layer 11 is provided, for example, over the whole of the semi-insulating substrate 21, for example. The first contact layer 11 is for electrically coupling a first electrode 31 and the first light reflecting layers 12 of the plurality of semiconductor stacked bodies 10. The first electrode 31 is described below. In other words, the first contact layer 11 also serves as a common anode for the plurality of semiconductor stacked bodies 10. The first contact layer 11 corresponds to a specific example of a "semiconductor layer" according to the present disclosure.

The first light reflecting layer 12 is disposed between the first contact layer 11 and the active layer 13. The first light reflecting layer 12 is opposed to the second light reflecting layer 14 with the active layer 13 interposed in between. The first light reflecting layer 12 resonates the light generated in the active layer 13 between the first light reflecting layer 12 and the second light reflecting layer 14. The first light reflecting layer 12 corresponds to a specific example of a "first light reflecting layer" according to the present disclosure. The first light reflecting layer 12 is included in the ridge section X of the semiconductor stacked body 10.

The first light reflecting layer 12 is a DBR (Distributed Bragg Reflector) layer in which low refractive index layers (not illustrated) and high refractive index layers (not illustrated) are alternately stacked. Each of the low refractive index layers includes, for example, p-type Alₓ₁Ga₁₋ₓ1As (0 < x1 ≤ 1) having an optical thickness of λ×1/4N and each of the high refractive index layers includes, for example, p-type Alₓ₂Ga₁₋ₓ₂As (0 ≤ x2 < x1) having an optical thickness of λ×1/4n. λ represents the oscillation wavelength of laser light emitted from each of the light emitting regions and n represents the refractive index. In the present embodiment, the first light reflecting layer 12 including a p-type semiconductor serves as the ridge section X, thereby confining the currents injected from the first electrode 31 into the active layer 13. This increases the current injection efficiency.

The active layer 13 is provided between the first light reflecting layer 12 and the second light reflecting layer 14. The active layer 13 includes, for example, an aluminum-gallium-arsenide (AlGaAs)-based semiconductor material. In the active layer 13, the holes and electrons injected from the first electrode 31 and a second electrode 32 undergo radiative recombination to generate stimulated emission light. The region of the active layer 13 opposed to the current injection region 15A serves as a light emitting region. For example, undoped Al_{X3}Ga_{1-X3}As (0 ≤ X3 ≤ 0.45) is usable for the active layer 13. The active layer 13 may have a multi quantum well (MQW: Multi Quantum Well) structure of GaAs and AlGaAs, for example. Additionally, the active layer 13 may have a multi quantum well structure of indium gallium arsenide (InGaAs) and AlGaAs. The active layer 13 corresponds to a specific example of an "active layer" according to the present disclosure.

The second light reflecting layer 14 is a DBR layer disposed between the active layer 13 and the second electrode 32. The second light reflecting layer 14 is opposed to the first light reflecting layer 12 with the active layer 13 interposed in between. The second light reflecting layer 14 corresponds to a specific example of a "second light reflecting layer" according to the present disclosure.

The second light reflecting layer 14 has a stacked structure in which low refractive index layers and high refractive index layers are alternately superimposed. A low refractive index layer is n-type Al_{X4}Ga_{1-X4}As (0 < X4 ≤ 1) having, for example, an optical film thickness of λ/4n. A high refractive index layer is n-type Al_{X5}Ga_{1-X5}As (0 ≤ X5 < X4) having, for example, an optical film thickness of λ/4n.

The second contact layer 15 includes, for example, a GaAs-based semiconductor having electrical conductivity. The second contact layer 15 includes, for example, n-type GaAs.

The insulating film 16 is for protecting the surface of each of the semiconductor stacked bodies 10. The insulating film 16 is formed to cover the side surfaces of each of the semiconductor stacked bodies 10. Specifically, the insulating film 16 is formed to cover the side surfaces of the first light reflecting layer 12 included in the ridge section X, the upper surface and the side surfaces of the active layer 13, the side surfaces of the second light reflecting layer 14, and the side surfaces of the second contact layer 15. The insulating film 16 includes, for example, a single layer film such as silicon nitride (SiN) or silicon oxide (SiO₂) or a stacked film.

The buried layer 17 is provided around the ridge section X with the insulating film 16 interposed in between to fill the ridge section X and form, for example, substantially the same side surfaces as the side surfaces of the active layer 13 and the second light reflecting layer 14. The buried layer 17 is formed to include, for example, any of a dielectric material, a resin material, and a metal material. Examples of the dielectric material include silicon nitride (SiN), silicon oxide (SiO₂), aluminum oxide (Al₂O₃), or the like. Examples of the resin material include a benzocyclobutene (BCB) resin material, a polyimide (PI)-based resin material, an acrylic-based resin material, and the like. Examples of the metal material include titanium (Ti), platinum (Pt), gold (Au), aluminum (Al), and the like. It is possible to use the metal material described above as a single layer film or a stacked film. The buried layer 17 is used by combining one or two or more of the dielectric material, the resin material, and the metal material described above.

The semi-insulating substrate 21 is a support substrate on which the plurality of semiconductor stacked bodies 10 is integrated. The semi-insulating substrate 21 is a substrate different from the substrate (e.g., crystal growth substrate 41) on which each of the semiconductor stacked bodies 10 described above is formed. The semi-insulating substrate 21 includes, for example, a GaAs-based semiconductor including, for example, no impurities. In addition, the semi-insulating substrate 21 is not necessarily limited to a typical semi-insulating substrate as long as the semi-insulating substrate 21 is low in carrier concentration and absorbs less laser light. For example, it is possible to use a substrate having a p-type or n-type carrier concentration of 5×10¹⁷ cm⁻³ or less as the semi-insulating substrate 21.

The first electrode 31 is provided on the first contact layer 11. The first electrode 31 is formed by using, for example, a multilayered film of titanium (Ti)/platinum (Pt)/gold (Au).

The second electrode 32 is provided on the semiconductor stacked body 10. Specifically, the second electrode 32 is provided on the second contact layer 15. The second electrode 32 is formed by using, for example, a multilayered film of gold-germanium (Au-Ge)/nickel (Ni)/gold (Au).

In a case where predetermined voltages are applied to the first electrode 31 and the second electrode 32, voltages are applied from the first electrode 31 and the second electrode 32 to the semiconductor stacked body 10 in the semiconductor laser 1. This injects a hole from the first electrode 31 and injects an electron from the second electrode 32 in the light emitting region. The recombination of the electron and the hole generates light. Light is resonated and amplified between the first light reflecting layer 12 and the second light reflecting layer 14 and laser light L is emitted from the back surface (surface 21S2) of the semi-insulating substrate 21.

### (1-2. Method of Manufacturing Semiconductor Laser)

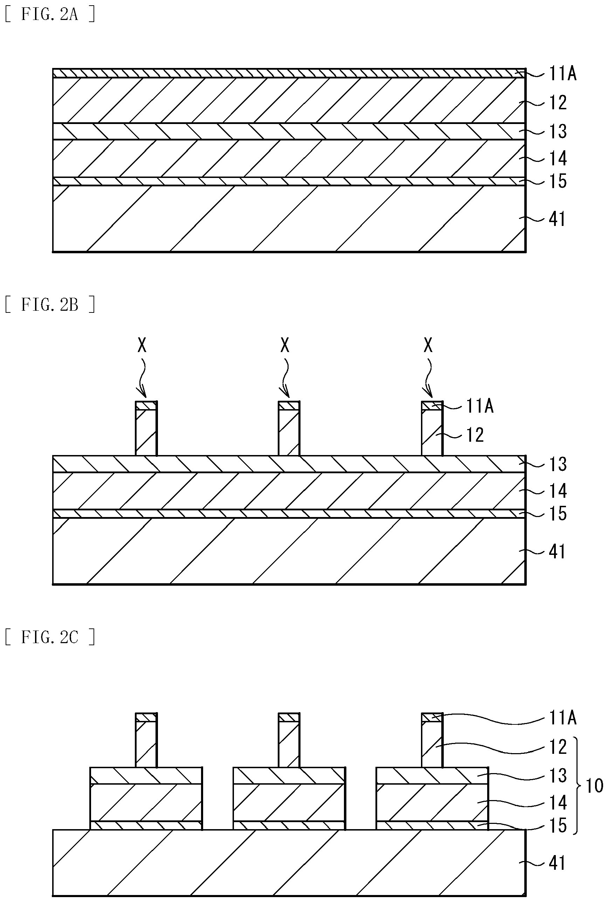

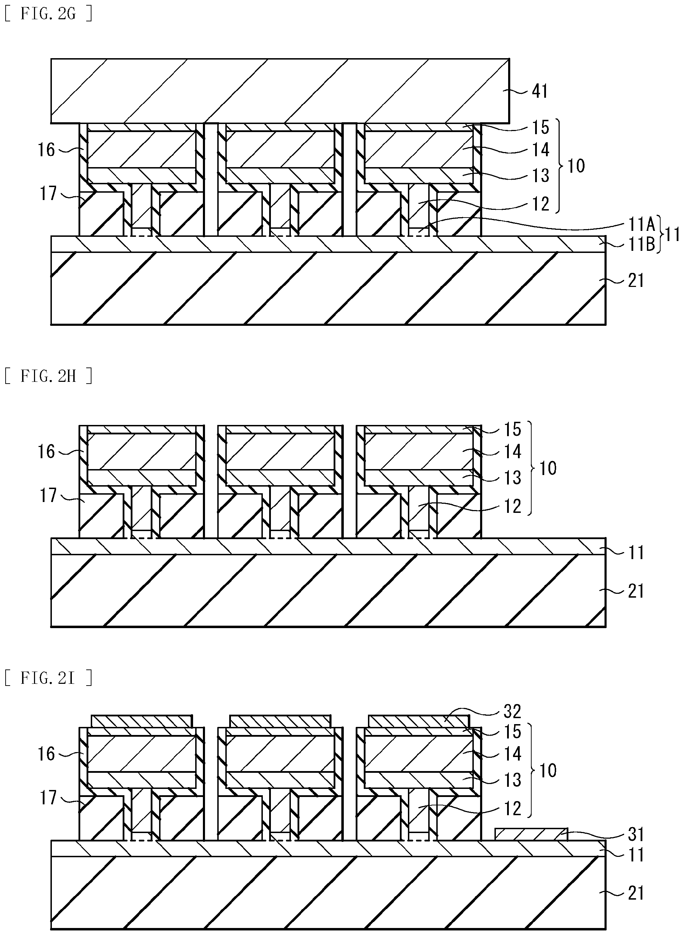

Next, a method of manufacturing the semiconductor laser 1 is described with reference to FIGs. 2A to 2I.

First, as illustrated in FIG. 2A, the respective compound semiconductor layers included in the second contact layer 15, the second light reflecting layer 14, the active layer 13, the first light reflecting layer 12, and the first contact layer 11A are formed in this order on the crystal growth substrate 41 including, for example, n-type GaAs, for example, in an epitaxial crystal growth method such as an organometallic vapor growth (Metal Organic Chemical Vapor Deposition: MOCVD) method. In this case, for example, a methyl-based organic metal gas such as trimethylaluminum (TMAl), trimethylgallium (TMGa), or trimethylindium (TMIn) and an arsine (AsH₃) gas are used as raw materials of the compound semiconductor, disilane (Si₂H₆), for example, is used as a raw material of a donor impurity, and carbon tetrabromide (CBr₄), for example, is used as a raw material of an acceptor impurity.

Subsequently, as illustrated in FIG. 2B, a resist film (not illustrated) having a predetermined pattern is, for example, formed and this resist film is then used as a mask to selectively etch the first contact layer 11A and the first light reflecting layer 12. In this case, it is preferable to use, for example, RIE (Reactive Ion Etching) with a Cl-based gas. This forms the ridge section X.

Next, as illustrated in FIG. 2C, a resist film (not illustrated) having a predetermined pattern is formed on the ridge section X and the active layer 13 and this resist film is then used as a mask to selectively etch the active layer 13 and the second light reflecting layer 14 and separate the active layer 13, the second light reflecting layer 14, and the second contact layer 15 for each of the light emitting regions (semiconductor stacked bodies 10).

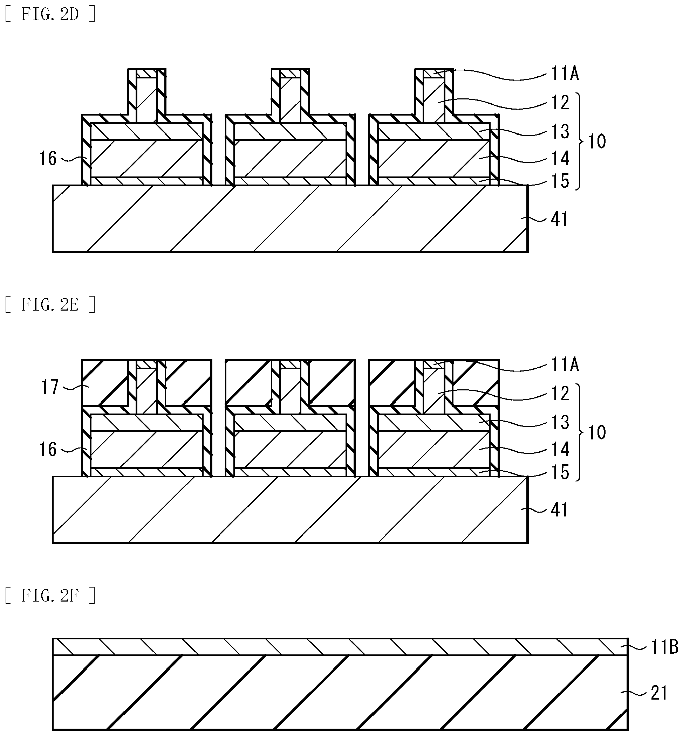

Subsequently, as illustrated in FIG. 2D, the insulating film 16 is formed that covers the side surfaces of the ridge section X, the upper surface and the side surfaces of the active layer 13, and the side surfaces of the second light reflecting layer 14. The insulating film 16 is formed by forming, for example, a silicon nitride (SiN) film on the upper surface and the side surfaces of the ridge section X, the upper surface and the side surfaces of the active layer 13, the side surfaces of the second light reflecting layer 14, the side surfaces of the second contact layer 15, and the crystal growth substrate 41 by using, for example, a chemical vapor growth (CVD: Chemical Vapor Deposition) method or an atomic layer deposition (ALD: Atomic Layer Deposition) method and then forming a resist film (not illustrated) having a predetermined pattern on the SiN film and performing etching such as RIE to expose the upper surface (specifically, the front surface of the first contact layer 11A) of the ridge section X. In this case, the SiN film on the crystal growth substrate 41 is also removed. It is to be noted that the SiN film on the crystal growth substrate 41 may be removed at the same time as the separation of the crystal growth substrate 41 described below.

Next, as illustrated in FIG. 2E, the buried layer 17 is formed around the ridge section X. The buried layer 17 is formed by forming, for example, a resist pattern and then forming a film of a metal material and applying a resin material around the ridge section X. After that, the respective semiconductor stacked bodies 10 are divided, for example, by a RIE process, thereby forming the buried layer 17 illustrated in FIG. 2E.

Subsequently, as illustrated in FIG. 2F, a first contact layer 11B is grown in advance on the semi-isolating substrate 21, for example, in an epitaxial crystal growth method such as a MOVCD method to have, for example, a thickness of 2 µm. The first contact layer 11B has, for example, a p-type carrier concentration of 3×10¹⁹ cm⁻³.

Next, as illustrated in FIG. 2G, the first contact layer 11B on the semi-insulating substrate 21 and the first contact layer 11A provided on the first light reflecting layer 12 of the ridge section X are joined. Solid-state welding is usable to join the first contact layer 11A and the first contact layer 11B by activating the front surfaces of the first contact layers 11A and 11B and then bringing them into close contact with a load applied, for example, under a high vacuum condition while heating them, for example, at 150°C.

Subsequently, as illustrated in FIG. 2H, the crystal growth substrate 41 is removed, for example, by a polishing process and wet etching. After that, as illustrated in FIG. 21, the first electrode 31 and the second electrodes 32 are respectively formed on the first contact layer 11 and above the second light reflecting layers 14. This completes the semiconductor laser 1. The first contact layer 11 of the semiconductor laser 1 fabricated in this way has a level difference between the ridge section X and the region around there. In addition, the semiconductor laser 1 has a non-continuous lattice plane at the interface between the first contact layer 11B and the first contact layer 11A.

FIG. 3 schematically illustrates an example of a configuration of a light emitting apparatus in which the semiconductor laser 1 illustrated in FIG. 1 is mounted on a mounting substrate 51. The light emitting apparatus has a configuration in which the semiconductor laser 1 illustrated in FIG. 1 is, for example, flip-chip mounted on the mounting substrate 51. The flip-chip mounting is mounting the first electrode 31 and the second electrodes 32 of the semiconductor laser 1 to be opposed to the mounting substrate 51. The mounting substrate 51 includes, for example, a plurality of electrodes (not illustrated) on the front surface (surface 51S1). The plurality of electrodes is provided to have the respective patterns corresponding to the first electrode 31 and the second electrodes 32 of the semiconductor laser 1. The plurality of electrodes is electrically coupled, for example, by solder. The mounting substrate 51 may be provided with a drive circuit such as a power supply circuit for the semiconductor laser 1. In that case, a terminal of the drive circuit in itself may be configured to be coupled to the first electrode 31 and the second electrode 32 of the semiconductor laser 1.

### (1-3. Workings and Effects)

The semiconductor laser 1 according to the present embodiment is provided with the buried layer 17 around the ridge section X and the semi-insulating substrate 21 and the ridge section X are joined with the first contact layer 11 interposed in between. The first contact layer 11 has electrical conductivity. This makes it possible to increase the mechanical strength of the ridge section X. The following describes this.

In a typical ridge confinement type surface emitting laser, a ridge shape is formed in a p-type semiconductor section and the ridge width is reduced as much as possible to increase the current confinement effect. This causes the ridge confinement type surface emitting laser to have a structure in which a structure in which laser light is emitted on not the front surface side, but the back surface side. The ridge is formed on the front surface side. The substrate is located on the back surface side. However, in a case of the use of a substrate having electrical conductivity, laser beam is absorbed by the substrate, raising an issue about lower laser oscillation characteristics.

Meanwhile, in a case where a compound semiconductor is epitaxially grown on a semi-insulating substrate, less laser light is absorbed, but the reliability of the device, for example, in an energization operation is reduced because the semi-insulating substrate has a high crystal defect density. Further, a ridge shape is formed in a p-type semiconductor section and it is thus difficult in terms of processing to fabricate a laser array device having an anode common structure.

In addition, as described above, an optical semiconductor device has been reported that has a p-GaAs substrate and a minute protrusion (minute region) joined to achieve back surface emission from the minute protrusion side. However, this optical semiconductor device easily receives mechanical stress on the minute protrusion, raising an issue about insufficient reliability. In addition, there is provided a support structure on the p-GaAs substrate side to increase the junction strength between the p-GaAs substrate and the minute protrusion. This complicates manufacturing steps and raises an issue about higher manufacturing cost.

In contrast, in the present embodiment, the buried layer 17 is provided around the first light reflecting layer 12 included in the ridge section X. In a case where the ridge section X and the semi-insulating substrate 21 are joined, the buried layer 17 is brought into contact with the junction surface with the semi-insulating substrate 21 along with the ridge section X. This increases the mechanical strength of the ridge section X.

As described above, the semiconductor laser 1 according to the present embodiment is provided with the buried layer 17 around the ridge section X and the semi-insulating substrate 21 and the ridge section X are joined. This makes it possible to increase the mechanical strength of the ridge section X. This makes it possible to increase the reliability.

In addition, as described above, there is no need to provide the substrate side with a support structure or the like that supports the ridge section X. This makes it possible to simplify the manufacturing steps and reduce the manufacturing cost.

Further, the semiconductor stacked body 10 having a light emitting region configured to emit laser light is epitaxially grown on a substrate (crystal growth substrate 41) different from the semi-insulating substrate 21 and then joined to the semi-insulating substrate 21. This makes it possible to form the semiconductor stacked body 10 having a lower crystal defect density. In addition, the laser light L emitted from the light emitting region of the semiconductor stacked body 10 is not absorbed by the substrate, but it is possible to emit the laser light L from the back surface (surface 21S2) of the semi-insulating substrate 21. This achieves favorable laser oscillation characteristics.

Furthermore, in the present embodiment, the ridge section X of the semiconductor stacked body 10 and the semi-insulating substrate 21 are joined with the first contact layer 11 interposed in between. The first contact layer 11 has electrical conductivity. It is thus possible to apply a voltage to the ridge section X without forming any electrode. In other words, it is possible to achieve a laser array having an anode common structure in which a ridge structure is included.

The following describes modification examples (modification examples 1 to 3) and an application example of the present disclosure. The following assigns the same signs to components similar to those of the embodiment described above and omits descriptions thereof as appropriate.

### <2. Modification Examples>

### (2-1. Modification Example 1)

FIG. 4 schematically illustrates an example of a cross-sectional configuration of a light emitting device (semiconductor laser 2) according to a modification example 1 of the present disclosure. In the embodiment described above, the example has been described in which the first light reflecting layer 12 including, for example, a p-type AlGaAs-based semiconductor serves as the ridge section X and is joined to the semi-insulating substrate 21 with the first contact layer 11 interposed in between. The first contact layer 11 includes a p-type GaAs-based semiconductor. This is not, however, limitative. For example, as illustrated in FIG. 4, the second light reflecting layer 14 including, for example, an n-type AlGaAs-based semiconductor may serve as the ridge section X and be joined to the semi-insulating substrate 21 with the second contact layer 15 interposed in between. The second contact layer 15 includes an n-type GaAs-based semiconductor.

It is also possible in the semiconductor laser 2 according to the present modification example to achieve effects similar to those of the embodiment described above.

### (2-2. Modification Example 2)

FIG. 5 schematically illustrates an example (semiconductor laser 3A) of a cross-sectional configuration of a light emitting device according to a modification example 2 of the present disclosure. FIG. 6 schematically illustrates another example (semiconductor laser 3B) of the cross-sectional configuration of the light emitting device according to the modification example 2 of the present disclosure. FIG. 7 schematically illustrates another example (semiconductor laser 3C) of the cross-sectional configuration of the light emitting device according to the modification example 2 of the present disclosure.

In the embodiment described above, the example has been described in which a p-type GaAs-based semiconductor layer having a p-type carrier concentration of 3×10¹⁹ cm⁻³ is provided on the semi-insulating substrate 21 as a portion (first contact layer 11B) of the first contact layer 11, for example, in an epitaxial crystal growth method such as a MOVCD method. However, for example, as illustrated in FIG. 5, a p-type GaAs-based semiconductor substrate (first contact layer 61) may be bonded. Alternatively, for the crystal growth substrate 41, a III-V group compound semiconductor substrate may be bonded such as an InP substrate, an AlGaAs substrate, or an AlGaInP substrate.

Further, for example, as illustrated in FIG. 6, the dielectric layer 22 including, for example, silicon oxide (SiO₂), silicon nitride (SiN), aluminum oxide (Al₂O₃), or the like may be provided between the semi-insulating substrate 21 and the first contact layer 61. Alternatively, as illustrated in FIG. 7, there may be provided a transparent electrically conductive layer 23 including, for example, ITO or the like between the semi-insulating substrate 21 and the first contact layer 61. As the first contact layer 61, in a case of the use of a material that is not lattice-matched with a GaAs substrate such as a III-V group compound semiconductor substrate including an InP substrate, an AlGaAs substrate, an AlGaInP substrate, or the like or a material having a thermal expansion coefficient different from that of the GaAs substrate, the dielectric layer 22 or the transparent electrically conductive layer 23 is provided between the semi-insulating substrate 21 and the first contact layer 61. This reduces strain stress and makes it possible to form a more stable junction substrate.

### (2-3. Modification Example 3)

FIG. 8 schematically illustrates an example (semiconductor laser 4A) of a cross-sectional configuration of a light emitting device according to a modification example 3 of the present disclosure. FIG. 9 schematically illustrates another example (semiconductor laser 4B) of the cross-sectional configuration of the light emitting device according to the modification example 3 of the present disclosure.

In the embodiment described above, the example has been described in which the active layer 13, the second light reflecting layer 14, and the second contact layer 15 are separated from each other for each of the semiconductor stacked bodies 10, but the active layer 13, the second light reflecting layer 14, and the second contact layer 15 may be formed as common layers between the respective semiconductor stacked bodies 10 as with the semiconductor lasers 4A and 4B illustrated in FIGs. 8 and 9. In that case, the buried layer 17 may be formed around each of the ridge sections X for each of the ridge sections X, for example, as illustrated in FIG. 8. Alternatively, in a case where the respective ridge sections X have wide intervals, the buried layer 17 may be continuously buried between the respective ridge sections X, for example, as illustrated in FIG. 9.

It is also possible in the semiconductor lasers 4A and 4B according to the present modification example to achieve effects similar to those of the embodiment described above.

### <3. Application Example>

The present technology is applicable to a variety of electronic apparatuses including a semiconductor laser. For example, the present technology is applicable to a light source included in a portable electronic apparatus such as a smartphone, a light source of each of a variety of sensing apparatuses that each sense a shape, an operation, and the like, or the like.

FIG. 10 is a block diagram illustrating a schematic configuration of a distance measurement system (distance measurement system 200) in which a light emitting apparatus in which the semiconductor laser 1 described above is used is used, for example, as a lighting apparatus 100. The distance measurement system 200 measures distance in the ToF method. The distance measurement system 200 includes, for example, the lighting apparatus 100, a light receiving unit 210, a control unit 220, and a distance measurement unit 230.

The lighting apparatus 100 includes, for example, the semiconductor laser 1 illustrated in FIG. 1 or the like as a light source. The lighting apparatus 100 generates illumination light, for example, in synchronization with a light emission control signal CLKp of a rectangular wave. In addition, the light emission control signal CLKp is not limited to the rectangular wave as long as it is a periodic signal. For example, the light emission control signal CLKp may be a sine wave.

The light receiving unit 210 receives the reflected light that is reflected from an irradiation target 300 and detects, whenever a period of a vertical synchronization signal VSYNC elapses, the amount of light received within the period. For example, a periodic signal of 60 hertz (Hz) is used as the vertical synchronization signal VSYNC. In addition, in the light receiving unit 210, a plurality of pixel circuits is disposed in a two-dimensional lattice shape. The light receiving unit 210 supplies the image data (frame) corresponding to the amount of light received in these pixel circuits to the distance measurement unit 230. It is to be noted that the frequency of the vertical synchronization signal VSYNC is not limited to 60 hertz (Hz), but may be 30 hertz (Hz) or 120 hertz (Hz).

The control unit 220 controls the lighting apparatus 100. The control unit 220 generates the light emission control signal CLKp and supplies the lighting apparatus 100 and the light receiving unit 210 with the light emission control signal CLKp. The frequency of the light emission control signal CLKp is, for example, 20 megahertz (MHz). It is to be noted that the frequency of the light emission control signal CLKp is not limited to 20 megahertz (MHz), but may be, for example, 5 megahertz (MHz).

The distance measurement unit 230 measures the distance to the irradiation target 300 in the ToF method on the basis of the image data. This distance measurement unit 230 measures the distance for each of the pixel circuits and generates a depth map that indicates the distance to the object for each of the pixels as a gradation value. This depth map is used, for example, for image processing of performing a blurring process to the degree corresponding to the distance, autofocus (AF) processing of determining the focused focal point of a focus lens in accordance with the distance, or the like.

Although the present disclosure has been described above with reference to the embodiment and the modification examples 1 to 3 and the application example, the present disclosure is not limited to the embodiment and the like described above. A variety of modifications are possible. For example, the layer configuration of the semiconductor laser 1 described in the embodiment described above is an example and another layer may be further included. In addition, the materials of each of the layers are also examples. Those described above are not limitative.

It is to be noted that the effects described herein are merely illustrative and non-limiting. In addition, other effects may be provided.

It is to be noted that the present technology may be configured as below. According to the present technology having the following configurations, the semiconductor stacked body includes the ridge section and is provided with the buried layer around the ridge section and the ridge section of the semiconductor stacked body is joined to the first surface of the semi-insulating substrate with the semiconductor layer interposed in between. The semiconductor layer has electrical conductivity. This increases the mechanical strength of the ridge section and makes it possible to increase the reliability.
(1) A light emitting device including:
   a semi-insulating substrate having a first surface and a second surface that are opposed to each other;
   a semiconductor layer that is stacked on the first surface of the semi-insulating substrate, the semiconductor layer having electrical conductivity;
   a semiconductor stacked body that is stacked above the first surface of the semi-insulating substrate with the semiconductor layer interposed in between, the semiconductor stacked body having a light emitting region and including a ridge section on the semi-insulating substrate side, the light emitting region being configured to emit laser light;
   a buried layer that is provided around the ridge section of the semiconductor stacked body;and
   a non-continuous lattice plane that is provided between the semi-insulating substrate and the semiconductor stacked body.
(2) The light emitting device according to (1), in which the semiconductor stacked body has a first light reflecting layer, an active layer, and a second light reflecting layer stacked in order from the semi-insulating substrate side.
(3) The light emitting device according to (2), in which the first light reflecting layer of the semiconductor stacked body is included in the ridge section.
(4) The light emitting device according to any one of (1) to (3), in which the buried layer includes at least one of a dielectric material, a resin material, or a metal material.
(5) The light emitting device according to any one of (1) to (4), further including:
   a first electrode that is provided on a front surface of the semiconductor layer; and
   a second electrode that is provided on a front surface of the semiconductor stacked body opposite to the semi-insulating substrate, the second electrode being provided to be configured to apply a predetermined voltage to the semiconductor stacked body along with the first electrode.
(6) The light emitting device according to (5), in which the first electrode and the semiconductor stacked body are electrically coupled through the semiconductor layer.
(7) The light emitting device according to any one of (1) to (6), in which the semiconductor layer has a level difference between a stack region of the semiconductor stacked body and another region.
(8) The light emitting device according to any one of (1) to (7), further including a dielectric layer between the semi-insulating substrate and the semiconductor layer.
(9) The light emitting device according to any one of (1) to (7), further including an electrically conductive layer between the semi-insulating substrate and the semiconductor layer, the electrically conductive layer having light transmissivity.
(10) The light emitting device according to any one of (1) to (9), in which the semi-insulating substrate includes a substrate having a p-type or n-type carrier concentration of 5×10¹⁷ cm⁻³ or less.
(11) The light emitting device according to any one of (1) to (10), in which the laser light is emitted from the second surface of the semi-insulating substrate.
(12) The light emitting device according to any one of (1) to (11), including a plurality of the semiconductor stacked bodies each having the light emitting region.
(13) A method of manufacturing a light emitting device, the method including:
   forming a ridge section in a semiconductor stacked body having a light emitting region configured to emit laser light;
   forming a buried layer around the ridge section; and
   bonding the ridge section and a semi-insulating substrate with a semiconductor layer interposed in between, the semi-insulating substrate having a first surface and a second surface that are opposed to each other, the semiconductor layer having electrical conductivity.
(14) The method of manufacturing the light emitting device according to (13), including:
   forming a first semiconductor layer on the semiconductor stacked body as the semiconductor layer;
   forming a second semiconductor layer on the semi-insulating substrate as the semiconductor layer; and
   bonding the first semiconductor layer and the second semiconductor layer after forming the ridge section and the buried layer in the semiconductor stacked body.
(15) The method of manufacturing the light emitting device according to (14), including directly joining the second semiconductor layer to the first surface of the semi-insulating substrate.
(16) The method of manufacturing the light emitting device according to (14), including joining, after forming a dielectric layer on the first surface of the semi-insulating substrate, the second semiconductor layer to the first surface of the semi-insulating substrate with the dielectric layer interposed in between.
(17) The method of manufacturing the light emitting device according to (14), including joining, after forming an electrically conductive layer on the first surface of the semi-insulating substrate, the second semiconductor layer to the first surface of the semi-insulating substrate with the electrically conductive layer interposed in between, the electrically conductive layer having light transmissivity.

The present application claims the priority on the basis of Japanese Patent Application No. 2019-230070 filed on December 20, 2019 with Japan Patent Office, the entire contents of which are incorporated in the present application by reference.

It should be understood by those skilled in the art that various modifications, combinations, sub-combinations, and alterations may occur depending on design requirements and other factors insofar as they are within the scope of the appended claims or the equivalents thereof.

## Claims

1. A light emitting device comprising:
a semi-insulating substrate having a first surface and a second surface that are opposed to each other;
a semiconductor layer that is stacked on the first surface of the semi-insulating substrate, the semiconductor layer having electrical conductivity;
a semiconductor stacked body that is stacked above the first surface of the semi-insulating substrate with the semiconductor layer interposed in between, the semiconductor stacked body having a light emitting region and including a ridge section on the semi-insulating substrate side, the light emitting region being configured to emit laser light;
a buried layer that is provided around the ridge section of the semiconductor stacked body;and
a non-continuous lattice plane that is provided between the semi-insulating substrate and the semiconductor stacked body.

2. The light emitting device according to claim 1, wherein the semiconductor stacked body has a first light reflecting layer, an active layer, and a second light reflecting layer stacked in order from the semi-insulating substrate side.

3. The light emitting device according to claim 2, wherein the first light reflecting layer of the semiconductor stacked body is included in the ridge section.

4. The light emitting device according to claim 1, wherein the buried layer includes at least one of a dielectric material, a resin material, or a metal material.

5. The light emitting device according to claim 1, further comprising:
a first electrode that is provided on a front surface of the semiconductor layer; and
a second electrode that is provided on a front surface of the semiconductor stacked body opposite to the semi-insulating substrate, the second electrode being provided to be configured to apply a predetermined voltage to the semiconductor stacked body along with the first electrode.

6. The light emitting device according to claim 5, wherein the first electrode and the semiconductor stacked body are electrically coupled through the semiconductor layer.

7. The light emitting device according to claim 1, wherein the semiconductor layer has a level difference between a stack region of the semiconductor stacked body and another region.

8. The light emitting device according to claim 1, further comprising a dielectric layer between the semi-insulating substrate and the semiconductor layer.

9. The light emitting device according to claim 1, further comprising an electrically conductive layer between the semi-insulating substrate and the semiconductor layer, the electrically conductive layer having light transmissivity.

10. The light emitting device according to claim 1, wherein the semi-insulating substrate includes a substrate having a p-type or n-type carrier concentration of 5×10¹⁷ cm⁻³ or less.

11. The light emitting device according to claim 1, wherein the laser light is emitted from the second surface of the semi-insulating substrate.

12. The light emitting device according to claim 1, comprising a plurality of the semiconductor stacked bodies each having the light emitting region.

13. A method of manufacturing a light emitting device, the method comprising:
forming a ridge section in a semiconductor stacked body having a light emitting region configured to emit laser light;
forming a buried layer around the ridge section; and
bonding the ridge section and a semi-insulating substrate with a semiconductor layer interposed in between, the semi-insulating substrate having a first surface and a second surface that are opposed to each other, the semiconductor layer having electrical conductivity.

14. The method of manufacturing the light emitting device according to claim 13, comprising:
forming a first semiconductor layer on the semiconductor stacked body as the semiconductor layer;
forming a second semiconductor layer on the semi-insulating substrate as the semiconductor layer; and
bonding the first semiconductor layer and the second semiconductor layer after forming the ridge section and the buried layer in the semiconductor stacked body.

15. The method of manufacturing the light emitting device according to claim 14, comprising directly joining the second semiconductor layer to the first surface of the semi-insulating substrate.

16. The method of manufacturing the light emitting device according to claim 14, comprising joining, after forming a dielectric layer on the first surface of the semi-insulating substrate, the second semiconductor layer to the first surface of the semi-insulating substrate with the dielectric layer interposed in between.

17. The method of manufacturing the light emitting device according to claim 14, comprising joining, after forming an electrically conductive layer on the first surface of the semi-insulating substrate, the second semiconductor layer to the first surface of the semi-insulating substrate with the electrically conductive layer interposed in between, the electrically conductive layer having light transmissivity.
